Europäisches Patentamt

European Patent Office

Office européen des brevets

(11) Publication number: **0 202 718**
**A2**

# EUROPEAN PATENT APPLICATION

(21) Application number: **86200872.9**

(22) Date of filing: **21.05.86**

(51) Int. Cl.⁴: **H01L 21/20 , H01L 21/268**

(30) Priority: **22.05.85 US 736922**

(43) Date of publication of application:
**26.11.86 Bulletin 86/48**

(84) Designated Contracting States:
**DE FR GB NL**

(71) Applicant: **N.V. Philips' Gloeilampenfabrieken
Groenewoudseweg 1
NL-5621 BA Eindhoven(NL)**

(72) Inventor: **Ramesh, Subramanian c/o
Int.Octrooibureau B.V.
Prof. Holstlaan 6
NL-5656 AA Eindhoven(NL)**
Inventor: **Martinez, André M. c/o
Int.Octrooibureau B.V.
Prof. Holstlaan 6
NL-5656 AA Eindhoven(NL)**

(74) Representative: **Rensen, Jan Geert et al
Internationaal Octrooibureau B.V. Prof.
Holstlaan 6
NL-5656 AA Eindhoven(NL)**

(54) **A method of producing a semiconductor device comprising a monocrystalline silicon layer on a substrate.**

(57) A method of producing a semiconductor device comprising a monocrystalline layer of silicon on a substrate by which method a sublayer of silicon dioxide or a sublayer thermally matching said substrate is formed on said substrate, a recrystallizable layer of amorphous or polycrystalline silicon is superimposed on said sublayer, at least on capping insulating layer is formed on said thin buffer layer and then said recrystallizable layer is converted into a monocrystalline silicon layer. According to the invention, before forming the capping layer a thin buffer layer selected from the group consisting of silicon nitride, aluminium nitride and aluminium oxide is formed on said recrystallizable layer. Such a technique results in a semi-conductor device in which contamination of the recrystallized silicon layer by oxygen from capping-and sublayer is prevented.

A method of producing a semiconductor device comprising a monocrystalline silicon layer on substrate.

This invention relates to a method for producing a semiconductor device comprising a monocrystalline layer of silicon on a substrate, by which method a sublayer of silicon dioxide or a sublayer thermally matching said substrate is formed on said substrate, a recrystallizable layer of amorphous or polycrystalline silicon is superimposed on said sublayer, at least one capping insulating layer is formed on said thin buffer layer and then said recrystallizable layer is converted into a monocrystalline silicon layer.

Monocrystalline silicon layers on substrates are used in many semiconductor dev ices. Such layers are useful for producing large area device arrays for flat panel displays, dielectrically insulating devices for high voltage and high frequency integrated devices and for many other applications.

From H. Baumgart et al, Mat. Res. Soc. Symp. Proc. Vol. 33 (1984) a method of the kind set forth before is known.

The sublayer provides a clean insulating layer on top of the substrate and tends to reduce the tendency to cracking of the crystalline silicon layer due to the differences in thermal expansion coefficients between the substrate and the silicon layer. The capping layer acts to prevent agglomeration of the molten silicon during recrystallization and to prevent contamination of the polycrystalline silicon layer from atmospheric contaminants particularly during conversion of the recrystallizable layer to the monocrystalline layer and also acts as an insulator for the monocrystalline silicon layer during further fabrication.

However, the problem still exists of contamination of the recrystallized silicon layer by oxygen and other impurities from the capping layer and the sublayer particularly during conversion of the recrystallizable layer into the monocrystalline silicon layer. Further, the additional problem exists of the breaking up or the physical separation of the capping layer from the silicon layer during recyrstallization.

An object of this invention therefore is to provide a method for producing a monocrystalline layer of silicon on a substrate by converting a recrystallizable layer of amorphous or polycrystalline silicon on a substrate to a monocrystalline silicon layer while the recrystallizable layer is covered by at least one capping insulating layer which method minimizes the tendency to separation of the capping layers from the resultant monocrystalline silicon layer during recrystallization and also minimizes the contamination of the monocrystalline silicon layer from contaminants from the other layers.

Another object of this invention is to provide a novel laminated structure comprising an insulating capped monocrystalline layer of silicon on a substrate which structure is particularly adapted for conventional silicon technology for fabrication of transistor devices.

Therefore the method mentioned before, according to the invention, is characterized in that before forming the capping layer a thin buffer layer selected from the group consisting of silicon nitride, aluminium nitride and aluminium oxide is formed on said recyrstallizable layer.

Due to the fact that the thin buffer layer tends to wet both the recrystallizable layer and the capping layer there tends to be a marked decrease in the tendency for separation between the capping layer and the resultant monocrystalline silicon layer. Further, the buffer layer provides a barrier between the capping layer and the recrystallizable layer and thus minimizes contamination of the resultant monocrystalline silicon layer from oxygen and other contaminants from the capping layer particularly during recrystallization.

While the buffer layer, situated between the capping layer and the recrystallizable layer, acts to prevent breaking up and separation of the capping layer from the monocrystalline silicon layer and tends to minimize contamination of the monocrystalline silicon layer by contaminating the capping layer, contamination of the recrystallizable layer by contaminants from the sublayers may also be minimized by an additional thin buffer layer of silicon nitride, aluminium nitride or aluminium oxide contacting the opposing surfaces of the sublayer and the recrystallizable silicon layer. This additional thin buffer layer also tends to provide additional mechanical strength to the structure.

While most of the contamination of the monocrystalline-silicon layer takes place during recrystallization of the polycrystalline silicon layer, additional contamination may take place during subsequent fabrication. In such a case the thin buffer layers act to prevent further contamination of the monocrystalline silicon layer.

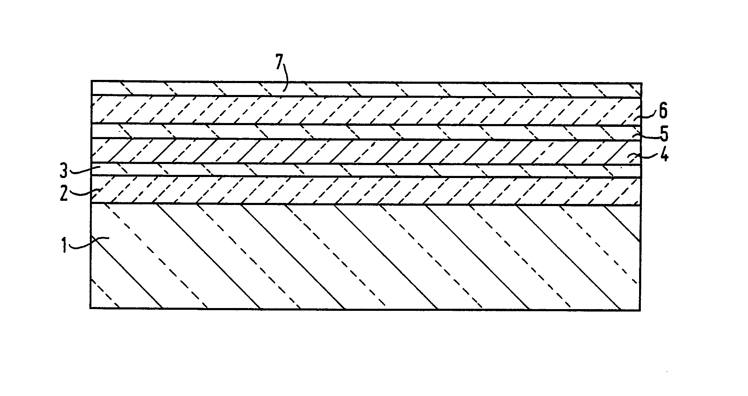

The invention will now be described in greater detail with reference to the drawing. The sole figure in the drawing is a cross-sectional view of a laminated structure of the invention.

As a substrate 1, materials well known in the semiconductor art may be employed: examples of such materials being quartz, glass, monocrystalline silicon, and sapphire. In general, the thickness of the substrate is about 0.2-2 mm, although the thickness of the substrate may vary considerably from this range.

One or more sublayers 2 of silicon dioxide, silicon enriched silicon dioxide such as silicon crystallites in a silicon dioxide matrix, a silicon dioxide glass or other materials which thermally match the substrate 1 are formed on the substrate 1 usually by a chemical vapor deposition (CVD) technique and preferably by a low pressure chemical vapor deposition (LPCVD) technique. In general, the total thickness of the sublayer or layers is about 50 nm -3 $\mu$m.

The sublayer 2 or semi-insulating film formed of silicon crystallites in a silicon dioxide matrix has been found to have a thermal expansion coefficient value lying between that of silicon and silicon dioxide or quartz. Such a semi-insulating film may be prepared at low pressures by a chemical vapor deposition (CVD) technique. For example, a mixtue of silane ($SiH_4$) and either nitrous oxide ($N_2O$) or carbon dioxide ($CO_2$) reacts in a heated and partially evacuated chamber to deposit a thin film of the semi-insulating layer onto the surface of an insulating substrate. Such a method is described by H. Baumgart et al, Mat. Res. Soc. Symp. Proc. Vol. 33 (1984)

Typical deposition techniques utilized for a mixture of silane and nitrous oxide involve use of a temperature of around 650°C, a pressure of about 0.3 Torr, and a silane to nitrous oxide ratio of 2:1. Under these conditions, the silane and nitrous oxide convert to amorphous silicon in a silicon dioxide matrix, and gaseous products of $N_2$ and $H_2O$ are given off. A semi-insulating film is then grown to a thickness of at least one micron.

The film formed by the reaction of $SiH_4$ and $N_2O$ consists essentially of a mixture of amorphous silicon and silicon dioxide.

After annealing by heating the film to a temperature of about 900°C-1100°C, by application of energy to a subsequently applied polycrystalline silicon layer, the amorphous silicon is converted to small silicon crystallites of 5nm-10nm in size,

A thin buffer layer 3 of silicon nitride, aluminium nitride or aluminium oxide of a thickness of 5-500 nm is deposited on the sublayer 2. Preferably, deposition is carried out by an LPCVD technique, with a layer of silicon nitride formed.

A recrystallizable layer 4 of amorphous or polycrystalline silicon of a thickness of about 0.2-20 $\mu$ is deposited on the sublayer 2 or, if present, on the thin buffer layer 3. Here too an LPCVD technique is preferably employed.

A thin buffer layer 5 similar to the above-mentioned thin buffer layer 3 is now applied to the layer of amorphous or polycrystalline silicon. Here too, the layer preferably is of silicon nitride and has a thickness of about 5-50 nm.

At least one capping insulating layer 6 is then deposited on the thin buffer layer. Preferably, a thin layer of silicon dioxide of a thickness of about .2-3 $\mu$m covered by a layer 7 of silicon nitride of a thickness of about 5-80 nm is employed. Here too, deposition is preferably carried out by a LPCVD technique.

Conversion of the recrystallizable layer 4 to monocrystalline silicon is then carried out preferably by use of a laser beam as described in J.G.K. Celler, J. Crystal Growth 53 (1980) 429-444 or by use of a strip heater as described in M.W. Geis, Appl. Phys. Lett. 40 (2), January 1982, 158-160.

Referring to the drawing, the following procedure was carried out:

On a quartz substrate of 1 of a thickness of about 0.5 mm, a 1 $\mu$m thick layer 2 of silicon dioxide was deposited by means of a LPCVD process employing a mixture of $O_2$ (125 sccm) and $SiH_4$ (80 sccm) at a pressure of about .3 Torr and at a temperature of about 475°C for a period of about 55 minutes. A 10 nm thick layer of silicon nitride 3 was then deposited on the silicon dioxide layer 2 by means of a LPCVD technique employing a mixture of $SiCl_2H_2$ 20.6 sccm) and $NH_3$ (61 sccm) at a pressure of .3 Torr at a temperature of about 800°C for a period of three minutes.

A polycrystalline layer 4 of silicon of a thickness of about 520 nm was then deposited on the silicon nitride layer 3 also by means of a LPCVD technique employing $SiH_4$ (60 sccm) at a pressure of .3 Torr and a temperature of 620°C for a period of 59 minutes.

In a manner similar to that employed for the deposition of silicon nitride layer 3 a 14 nm thick layer 5 of silicon nitride was deposited on the polycrystalline silicon layer 4.

A first capping layer 6 of silicon dioxide of a thickness of 2.2 $\mu$m was then deposited on the silicon nitride layer 5. A LPCVD technique similar to that used for the deposition of silicon dioxide layer 2 was employed but with a deposition time of about one hour 50 minutes.

A second capping layer 7 of silicon nitride of a thickness of about 700 nm was then deposited on the first capping layer 6 in a manner similar to that employed for silicon nitride layer 5 but with a deposition time of 22 minutes.

An alternate structure was fabricated in a similar manner, except that layer 2 was a semi-insulating film of a thickness of 1 μm of silicon crystallites in silicon dioxide as described previously.

Semiconductor devices may be fabricated according to methods known in the art from the laminated structure of the invention.

A CMOS inverter may be fabricated by the method described in J.F. Gibbons et al IEEE Electron Device Letters, Vol. EDL-1, No.6, June 1980, pages 117-188.

CMOS devices may also be fabricated by the method described in J.P. Colinge el al IEEE Trans. Electron Devices, Vol. ED-29, No.4, April 1982, pages 585-589.

**Claims**

1. A method of producing a semiconductor device comprising a monocrystalline layer of silicon on a substrate by which method a sublayer of silicon dioxide or a sublayer thermally matching said substrate is formed on said substrate, a recrystallizable layer of amorphous or polycrystalline silicon is superimposed on said sublayer, at least one capping insulating layer is formed on said thin buffer layer and then said recrystallizable layer is converted into a monocrystalline silicon layer, characterized in that before forming the capping layer a thin buffer layer selected from the group consisting of silicon nitride, aluminium nitride and aluminium oxide is formed on said recrystallizable layer.

2. A method according to Claim 1, characterized in that before forming a recrystallizable layer of amorphous or polycrystalline silicon a first thin buffer layer selected from the group consisting of silicon nitride, aluminium nitride and aluminium oxide is formed on the sublayer.

3. A method according to Claim 1 or 2, characterized in that the sublayer is a layer of silicon enriched silicon dioxide.

4. A method according to Claim 1, 2 or 3, characterized in that the buffer layers are layers of silicon nitride.

5. A method according to Claim 4, characterized in that the buffer layers are 5-50 nm thick.

6. A method according to Claim 1 or 2, characterized in that the capping layer consists of a layer of silicon dioxide and a superimposed layer of silicon nitride with said layer of silicon dioxide adjacent to the buffer layer.

7. A method according to one of Claims 1-6, characterized in that the substrate is quartz, glass, monocrystalline silicon or sapphire.

8. A method according to one of Claims 1-7, characterized in that the recrystallizable layer is converted into a monocrystalline silicon layer by irradiating said crystallizable layer with a high intensity light or heat source.